(19) Europäisches Patentamt
European Patent Office
Office européen des brevets

(11) Publication number: **0 162 230**
**A2**

# (12) EUROPEAN PATENT APPLICATION

(21) Application number: 85103537.8

(22) Date of filing: 25.03.85

(51) Int. Cl.$^4$: C 08 J 7/02

(30) Priority: 26.03.84 US 593046

(43) Date of publication of application:
27.11.85 Bulletin 85/48

(84) Designated Contracting States:
AT BE CH DE FR GB IT LI LU NL SE

(71) Applicant: UNION CARBIDE CORPORATION
Old Ridgebury Road
Danbury Connecticut 06817(US)

(72) Inventor: Rimsa, Stephen Benedict
175 Welsch Road
Lebanon New Jersey 08833(US)

(74) Representative: Schmied-Kowarzik, Volker, Dr. et al,
Patentanwälte Dr. V. Schmied-Kowarzik Dipl.-Ing. G. Dannenberg Dr. P. Weinhold Dr. D. Gudel Dipl.-Ing. S. Schubert Dr. P. Barz Siegfriedstrasse 8
D-8000 München 40(DE)

## (54) Method of restoring the surface of a thermoplastic substrate.

(57) Described herein is a method for restoring the surface of a substrate molded from a thermoplastic polymer after its surface has undergone conditioning by a strong oxidizing or reducing agent and/or mechanical abrasion which comprises exposing the surface of the substrate to solvent vapors for a period of time such that the surface has been restored to essentially that before conditioning.

EP 0 162 230 A2

0162230

## BACKGROUND OF THE INVENTION

This invention is directed to a method for restoring the surface of a substrate molded from a thermoplastic polymer after its surface has undergone conditioning by a strong oxidizing or reducing agent and/or mechanical abrasion such as RF plasma etching, which method comprises exposing the surface of the substrate to solvent vapors for a period of time such that the surface has been essentially restored to that before conditioning.

It is well known that a wide variety of thermoplastic polymers have been used as substrates for electrical components, such as circuit board substrates. These substrates have been molded from, for example, polyphenyloxide, polyphenylsulfide, polyimide and polyethersulfone. U.S. Patent Application Serial No. 516,863, filed in the name of J.E. Harris et al, on July 25, 1983, titled "A Composition Useful For Making Circuit Board Substrates and Electrical Connectors" (commonly assigned) describes a composition useful for making circuit board substrates and electrical connectors comprising a blend of a poly(ether sulfone) and a polysulfone. U.S. Patent Application Serial No. 566,298, filed in the name of H. Cao et al, on December 28, 1983, titled "A Polymer Useful For Molding Into A Circuit Board Substrate" (commonly assigned) describes a select polyarylethersulfone which is useful for molding into circuit board substrates. U.S. Patent Application Serial No. 448,376, filed in the name of J.E. Harris, on

December 9, 1982, titled "A Composition Useful For Making Circuit Board Substrates And/Or Electrical Connectors" (commonly assigned) describes a composition comprising a blend of a poly(aryl ether), a poly(etherimide) polymer, a fiber and a filler which is useful for making circuit board substrates and/or electrical connectors.

In order to prepare these substrates for use as circuit boards, they are generally electroplated by chemically conditioning the surface in a strong oxidizing agent, such as chromic acid. However, during the conditioning of the substrate a transparent substrate has a tendency to become opaque. This opacity results from the chemical "roughening" of the surface by the oxidizing agent. In many instances it is desirable to restore the surface of the substrate to its original transparent form. This is especially important when the substrate is used to hold an electrical circuit. In its transparent form the circuit on the substrate may be viewed when the electrical component is operating.

Surface restoration has been achieved by immersing the substrate, after its surface has undergone conditioning by a strong oxidizing agent, into a solution of a known solvent such as dimethyl formamide. However, immensing of the substrate in the solvent has several disadvantages such as stress cracking of the substrate, and solvent absorption by the substrate.

## THE INVENTION

It has now been found that the surface of a substrate molded from a thermoplastic polymer may be

restored, after its surface has undergone conditioning by a strong oxidizing or reducing agent and/or mechanical abrasion such as RF plasma etching, by exposing the surface of the substrate to solvent vapors for a period of time sufficient to restore the surface to essentially that before conditioning.

In the present invention the surface restoration of the substrate is effected essentially instantaneously. The hot solvent vapors melts or plasticize and reflows the surface of the substrate resulting in restoration of clarity or surface finish in the case of an opaque substrate. Further, no stress cracking of the substrate is apparent using this process.

In the practice of this invention the substrate surface to be treated is exposed to vapors of a solvent. The surface is exposed to the vapors usually in a container, so that the entire surface area is contacted by the vapors. The solvent may include methylene chloride, chloroform, carbon tetrachloride, trichloroethane, trichloroethylene, trichioromethylene, o-dichlorobenzene, acetone, methyl ethyl ketone, cyclohexanone, ethyl acetate, dimethyl acetamide, N-methyl pyrolidone, N,N-dimethylformamide, etc., with methylene chloride being preferred. The surface is contacted until clarity or surface finish, in the case of an opaque substrate, is restored. This contact time is between 0.5 and about 3 seconds.

The thermoplastic polymers which may be used herein include a polyarylate, a polyetherimide, a polyester polymer, an aromatic polycarbonate including polyestercarbonate, a poly(aryl ether) and the like, or combinations thereof.

A. Polyarylates

The polyarylates which are suitable for use in this invention are derived from a dihydric phenol and at least one aromatic dicarboxylic acid and have a reduced viscosity of from about 0.4 to greater than about 1.0, preferably from about 0.6 to about 0.8 dl/gm, as measured in chloroform (0.5 g/100ml chloroform) or other suitable solvent at 25°C.

A particularly desirable dihydric phenol is of the following formula:

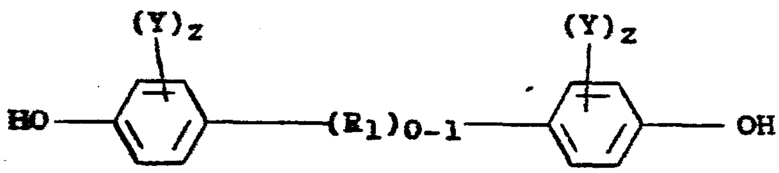

wherein Y is selected from, hydrogen, alkyl groups of 1 to 4 carbon atoms, chlorine or bromine, each z, independently, has a value of from 0 to 4, inclusive, and $R_1$ is a divalent saturated or unsaturated aliphatic hydrocarbon radical, particularly an alkylene or alkylidene radical having from 1 to 6 carbon atoms, or a cycloalkylidene or cycloalkylene radicals having up to and including 9 carbon atoms, O, CO, $SO_2$, or S. The dihydric phenols may be used individually or in combination.

The aromatic dicarboxylic acids that may be used in this invention include terephthalic acid, isophthalic acid, any of the naphthalene dicarboxylic acids and mixtures thereof, as well as alkyl substituted homologs of these carboxylic acids, wherein the alkyl group contains from 1 to about 4 carbon atoms, and acids containing other

inert substituents, such as halides, alkyl or aryl ethers, and the like. Acetoxybenzoic acid can also be used. Preferably, mixtures of isophthalic and terephthalic acids are used. The isophthalic acid to terephthalic acid ratio in the mixture is about 0:100 to about 100:0, while the most preferred acid ratio is about 75:25 to about 50:50. Also, from about 0.5 to about 20 percent of aliphatic diacids containing from 2 to about 10 carbon atoms, such as adipic acid, sebacic acid, and the like may be additionally used in the polymerization reaction.

The polyarylates of the present invention can be prepared by any of the well known prior art polyester forming reactions, such as the reaction of the acid chlorides of the aromatic dicarboxylic acids with the dihydric phenols; the reaction of the diaryl esters of the aromatic dicarboxylic acids with the dihydric phenols; or the reaction of the aromatic diacids with diester derivatives of the dihydric phenol. These processes are described in, for example, U.S. Patents 3,317,464; 3,948,856; 3,780,148; 3,824,213; and 3,133,898.

B. Polyetherimides

The polyetherimides suitable for use in this invention are well known in the art and are described in, for example, U.S. Patents 3,847,867, 3,838,097 and 4,107,147.

The polyetherimides are of the following formula:

(I) 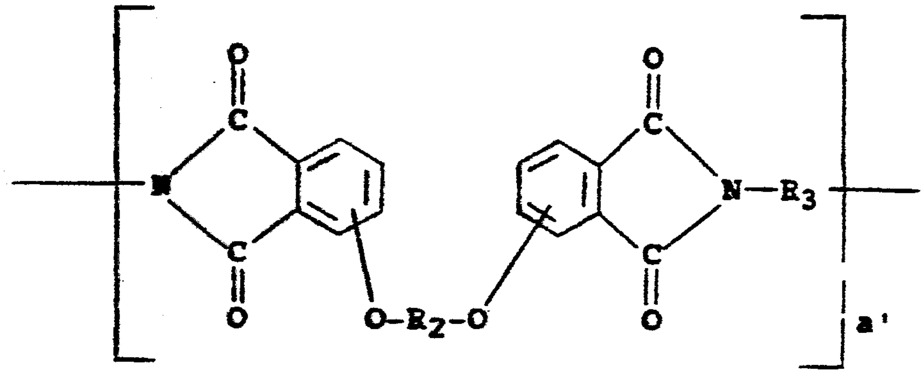

wherein a' is an integer greater than 1, preferably from about 10 to about 10,000 or more, $-O-R_2-O-$ is attached to the 3 or 4 and 3' or 4' positions and $R_2$ is selected from (a) a substituted or unsubstituted aromatic radical such as

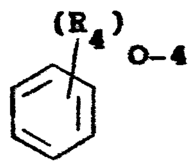

, or

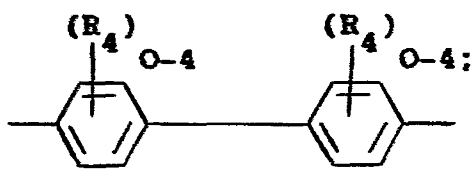

(b) a divalent radical of the formula:

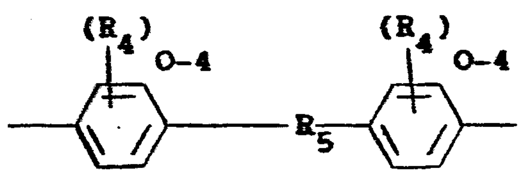

wherein $R_4$ is independently $C_1$ to $C_6$ alkyl, aryl or halogen and

$R_5$ is selected from -O-, -S-, $-\overset{O}{\overset{\|}{C}}-$, $-SO_2-$, -SO-,

alkylene of 1 to 6 carbon atoms, cycloalkylene of 4 to 8 carbon atoms, alkylidene of 1 to 6 carbon atoms or cycloalkylidene of 4 to 8 carbon atoms, $R_3$ is selected from an aromatic hydrocarbon radical having from 6 to 20 carbon atoms and halogenated derivatives thereof, or alkyl substituted derivatives thereof, wherein the alkyl group contains 1 to 6 carbon atoms, alkylene and cycloalkylene radicals having from 2 to 20 carbon atoms and $C_2$ to $C_8$ alkylene terminated polydiorganosiloxane or a divalent radical of the formula

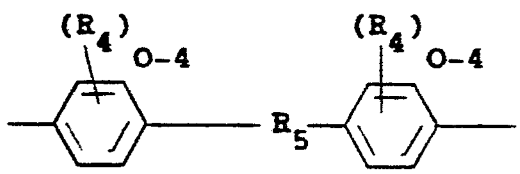

wherein $R_4$ and $R_5$ are as previously defined.

The polyetherimides may also be of the following formula:

(II)

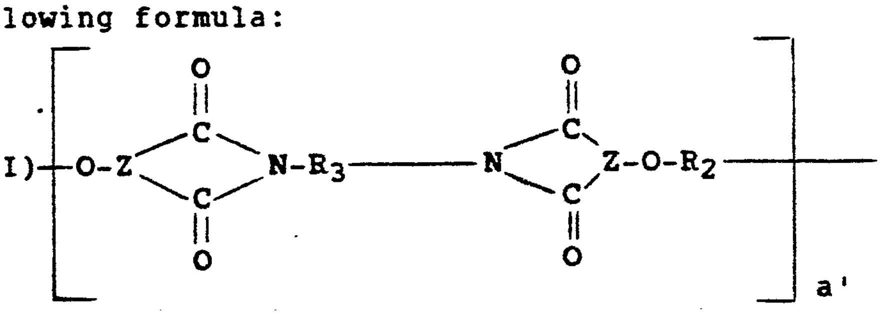

wherein -O-Z is a member selected from

(a)

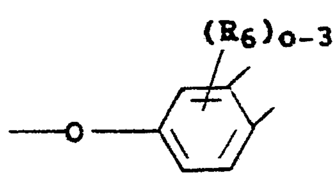

wherein $R_6$ is independently hydrogen, lower alkyl or lower alkoxy

(b) 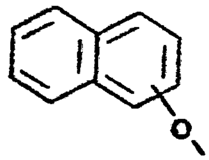 and,

(c) 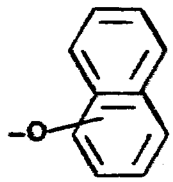

wherein the oxygen may be attached to either ring and located ortho or para to one of the bonds of the imide carbonyl groups, $R_2$ and $R_3$ and a' are as previously defined.

These polyetherimides are prepared by methods well known in the art as set forth in, for example, U.S. Patents 3,833,544, 3,887,588, 4,017,511, 3,965,125 and 4,024,110.

The polyetherimides of Formula (I) can, for example, be obtained by any of the methods well-known to those skilled in the art including the reaction of any aromatic bis(ether anhydride)s of the formula

(III) 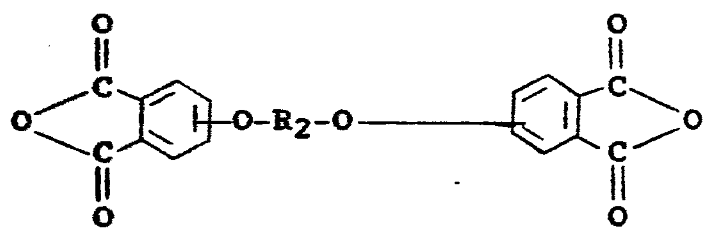

where $R_2$ is as defined hereinbefore, with a diamino compound of the formula

(IV) $H_2N-R_3-NH_2$

where $R_3$ is as defined hereinbefore. In general, the reactions can be advantageously carried out employing well-known solvents, e.g., o-dichlorobenzene, m-cresol/toluene, N,N-dimethylacetamide, etc., in which to effect interaction between the

dianhydrides and diamines, at temperatures of from about 20 to about 250°C. Alternatively, the polyetherimides can be prepared by melt polymerization of any dianhydrides of Formula III with any diamino compound of Formula IV while heating the mixture of the ingredients at elevated temperatures with concurrent intermixing. Generally, melt polymerization temperatures between about 200° to 400°C and preferably 230° to 300°C can be employed. Any order of addition of chain stoppers ordinarily employed in melt polymerizations can be employed. The conditions of the reaction and the proportions of ingredients can be varied widely depending on the desired molecular weight, intrinsic viscosity, and solvent resistance. In general, equimolar amounts of diamine and dianhydride are employed for high molecular weight polyetherimides, however, in certain instances, a slight molar excess (about 1 to 5 mole percent) of diamine can be employed resulting in the production of polyetherimides of Formula I have an intrinsic viscosity [n] greater than 0.2 deciliters per gram, preferably 0.35 to 0.60, or 0.7 deciliters per gram or even higher when measured in m-cresol at 25°C.

The aromatic bis(ether anhydride)s of Formula III include, for example,

2,2-bis[4-(2,3-dicarboxyphenoxy)phenyl]-propane dianhydride;

4,4'-bis(2,3-dicarboxyphenoxy)diphenyl ether dianhydride;

1,3-bis(2,3-dicarboxyphenoxy)benzene dianhydride;

4,4'-bis(2,3-dicarboxyphenoxy)diphenyl sulfide dianhydride;

1,4-bis(2,3-dicarboxyphenoxy)benzene dianhydride;

4,4'-bis(2,3-dicarboxyphenoxy)benzophenone dianhydride;

4,4'-bis(2,3-dicarboxyphenoxy)diphenyl sulfone dianhydride;

2,2-bis[4-(3,4-dicarboxyphenoxy)phenyl]-propane dianhydride;

4,4'-bis(3,4-dicarboxyphenoxy)diphenyl ether dianhydride;

4,4'-bis(3,4-dicarboxyphenoxy)diphenyl sulfide dianhydride;

1,3-bis(3,4-dicarboxyphenoxy)benzene dianhydride;

1,4-bis(3,4-dicarboxyphenoxy)benzene dianhydride;

4,4'-bis(3,4-dicarboxyphenoxy)benzophenone dianhydride;

4-(2,3-dicarboxyphenoxy)-4'-(3,4-dicarboxyphenoxy)diphenyl-2,2-propane dianhydride; etc. and mixures of such dianhydrides.

The organic diamines of Formula IV include, for example, m-phenylenediamine, p-phenylenediamine, 2,2-bis(p-aminophenyl)propane, 4,4'-diaminodiphenyl-methane, 4,4'-diaminodiphenyl sulfide, 4,4'-diaminodiphenyl sulfone, 4,4'-diaminodiphenyl ether, 1,5-diaminonaphthalene, 3,3'-dimethylbenzidine, 3,3'-dimethoxybenzidine,

The polyetherimides of formula (III) may, for example, be prepared by effecting reaction in the presence of a dipolar aprotic solvent of a

mixture of ingredients comprising, for instance, (1) a bis(nitrophthalimide) of the general formula:

(V) 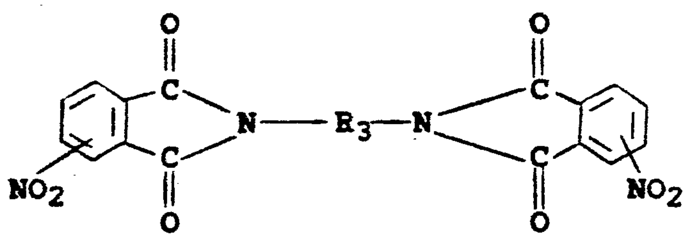

wherein $R_3$ is defined as hereinabove, and (2) an alkali metal salt of an organic compound of the general formula:

(VI) $MO-R_2-OM$

wherein M is an alkali metal and $R_2$ is defined as hereinabove.

The bis(nitrophthalimide) used in preparing the polymer is formed by reacting a diamine of the formula described above, $NH_2-R_3-NH_2$, with a nitro-substituted aromatic anhydride of the formula:

(VII) 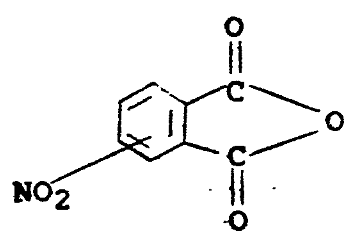

The molar ratio of diamine to anhydride should ideally be about 1:2 respectively. The initial reaction product is a bis(amide-acid) which is subsequently dehydrated to the corresponding bis(nitrophthalimide).

The diamines are described, <u>supra</u>.

The preferred nitrophthalic anhydrides useful in the present invention are 3-nitrophthalic anhydride, 4-nitrophthalic anhydride and mixtures thereof. These reactants are commercially available

in reagent grade. They may also be prepared by the nitration of phthalic anhydride using procedures described in Organic Syntheses, Collective Vol. I, Wiley (1948), page 408. Certain other closely related nitroaromatic anhydrides may also be used in the reaction and are illustrated for example by 2-nitronaphthalic anhydride, 1-nitro-2,3-naphthalenedicarboxylic anhydride and 3-methoxy-6-nitrophthalic anhydride, and the like.

With reference to the alkali metal salts of formula VI among the divalent carbocyclic aromatic radicals which $R_2$ may represent (mixtures of such radicals are also included) are, for instance, divalent aromatic hydrocarbon radicals of from 6 to 20 carbon atoms, such as phenylene, biphenylene, naphthylene, etc. Included are residues of, e.g. hydroquinone, resorcinol, chlorohydroquinone, etc. In addition, $R_2$ may be a residue of a dihydroxy diarylene compound in which the aryl nuclei are joined by either an aliphatic group, a sulfoxide group, sulfonyl group, sulfur, carbonyl group, oxygen, etc. Typical of such diarylene compounds are the following:

2,4-dihydroxydiphenylmethane;
bis(2-hydroxyphenyl)methane;
2,2-bis(4-hydroxyphenyl)propane;
bis(4-hydroxyphenyl)methane;
bis(4-hydroxy-5-nitrophenyl)methane;
bis(4-hydroxy-2,6-dimethyl-3-methoxyphenyl)methane;
1,1-bis(4-hydroxyphenyl)ethane;
1,2-bis(4-hydroxyphenyl)ethane;

1,1-bis(4-hydroxy-2-chlorophenyl)ethane;
1,1-bis(2,5-dimethyl-4-hydroxyphenyl)ethane;
1,3-bis(3-methyl-4-hydroxyphenyl)propane;
2,2-bis(3-phenyl-4-hydroxyphenyl)propane;
2,2-bis(3-isopropyl-4-hydroxyphenyl)propane;
2,2-bis(4-hydroxynaphthyl)propane;
hydroquinine;
naphthalene diols;
bis(4-hydroxyphenyl)ether;
bis(4-hydroxyphenyl)sulfide;
bis(4-hydroxyphenyl)sulfone; and the like.

When dialkali metal salts of formula VI are used with the compound illustrated by formula V, the ingredients are advantageously present in an equal molar ratio for optimum molecular weight and properties of the polymer. Slight molar excesses, e.g., about 0.001 to 0.10 molar excess of either the dinitro-substituted organic compound or of the dialkali metal salt of formula (VI) may be employed. When the molar ratios are approximately equal, the polymer is substantially terminated by a = $Z-NO_2$ at one end and a phenolic group at the other end. If there is a molar excess of one compound, that particular terminal group will predominate.

The conditions of reaction whereby the alkali-metal salt of formula VI is reacted with the dinitro-substituted organic compound of formula V can be varied widely. Generally, temperatures of the order of about 25 to about 150°C are advantageously employed, although it is possible to employ lower or higher temperature conditions depending on the ingredients used, the reaction

product sought, time of reaction, solvent employed, etc. In addition to atmospheric pressure, superatmospheric pressures and subatmospheric pressures may be employed depending upon the other conditions of reaction, the ingredients used, the speed at which it is desired to effect reaction, etc.

The time of reaction also can be varied widely depending on the ingredients used, the temperature, the desired yield, etc. It has been found that times varying from about 5 minutes to as much as 30 to 40 hours are advantageously employed to obtain the maximum yield and desired molecular weight. Thereafter the reaction product can be treated in the appropriate manner required to effect precipitation and/or separation of the desired polymeric reaction product. Generally, common solvents such as alcohols (e.g. methanol, ethanol, isopropyl alcohol, etc.) and aliphatic hydrocarbons (e.g. pentane, hexane, octane, cyclohexane, etc.) may be employed as precipitants for this purpose.

It is important that the reaction between the dinitro-substituted organic compound of formula V and the alkali-metal salt of formula VI (mixtures of such alkali-metal salts can also be used) be carried out in the presence of a dipolar aprotic solvent.

The polymerization is performed under anhydrous conditions usually using dipolar aprotic solvents such as dimethylsulfoxide which are added in varying amounts depending upon the particular polymerization. A total quantity of solvent, dipolar aprotic solvent or mixture of such solvent with an aromatic solvent sufficient to give a final

solution containing 10 to 20% by weight of polymer is preferably employed.

The preferred polyetherimides include those having repeating units of the following formula:

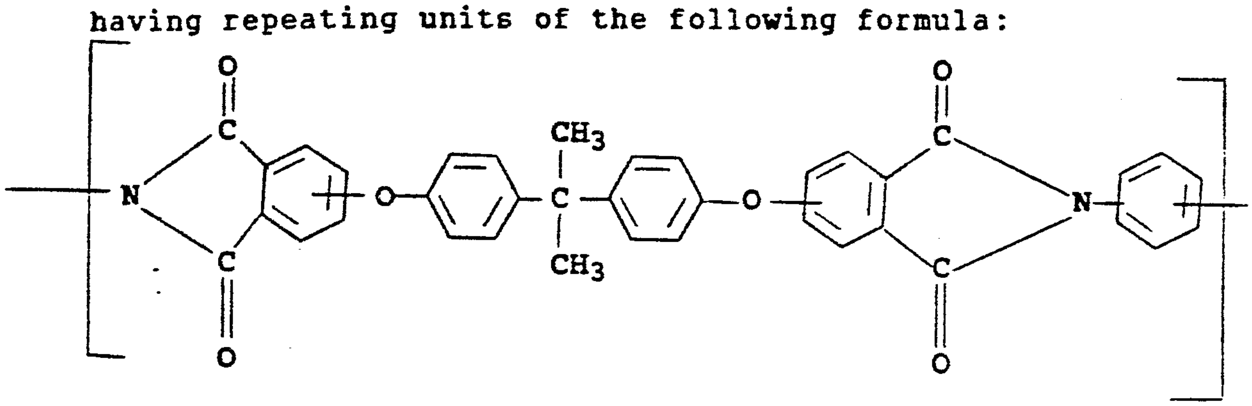

C. Polyesters

The polyesters which are suitable for use herein are derived from an aliphatic or cyloaliphatic diol, or mixtures thereof, containing from 2 to about 10 carbon atoms and at least one aromatic dicarboxylic acid. The polyesters which are derived from an aliphatic diol and an aromatic dicarboxylic acid have repeating units of the following general formula:

VIII 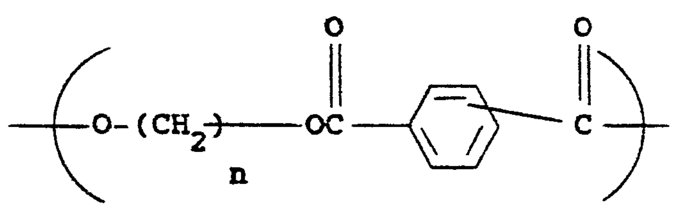

wherein n is an integer of from 2 to 10.

The preferred polyester is poly(ethylene terephthalate).

Also contemplated herein are the above polyesters with minor amounts, e.g., from 0.5 to about 2 percent by weight, of units derived from aliphatic acids and/or aliphatic polyols, to form

copolyesters. The aliphatic polyols include glycols, such as poly(ethylene glycol). These can be made following the teachings of, for example, U.S. Patents 2,465,319 and 3,047,539.

The polyesters which are derived from a cycloaliphatic diol and an aromatic dicarboxylic acid are prepared by condensing either the cis - or trans-isomer (or mixtures thereof) of, for example, 1,4-cyclohexanedimethanol with an aromatic dicarboxylic acid so as to produce a polyester having recurring units of the following formula:

(IX) 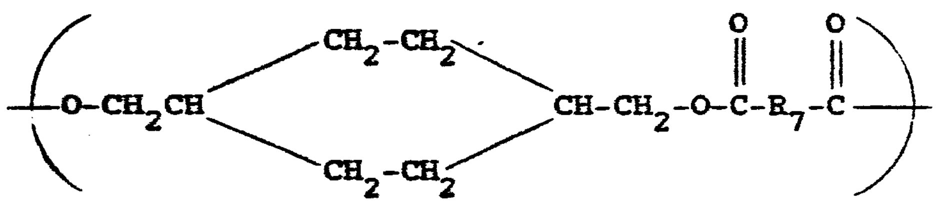

wherein the cyclohexane ring is selected from the cis- and trans- isomers thereof and $R_7$ represents an aryl radical containing 6 to 20 carbon atoms and which is the decarboxylated residue derived from an aromatic dicarboxylic acid.

Examples of aromatic dicarboxylic acids indicated by $R_7$ in formula IX, are isophthalic or terephthalic acid, 1,2-di(p-carboxyphenyl)ethane, 4,4'-dicarboxydiphenyl ether, etc., and mixtures of these. All of these acids contain at least one aromatic nucleus. Fused rings can also be present, such as in 1,4-or 1,5-naphthalenedicarboxylic acids. The preferred dicarboxylic acids are terephthalic acid or a mixture of terephthalic and isophthalic acids.

A preferred polyester may be derived from the reaction of either the cis-or trans-isomer (or a mixture thereof) of 1,4-cyclohexanedimethanol with a mixture of isophthalic and terephthalic acids. These polyesters have repeating units of the formula:

(X) 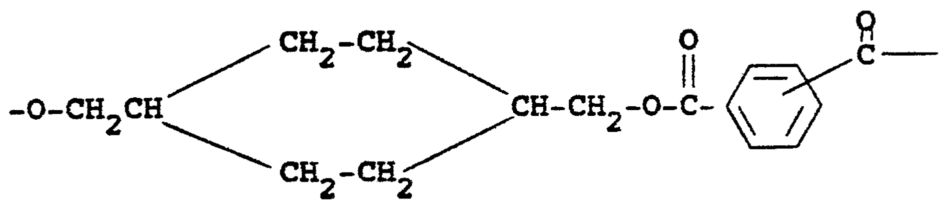

Another preferred polyester is a copolyester derived from a cyclohexane dimethanol, an alkylene glycol and an aromatic dicarboxylic acid. These copolyesters are prepared by condensing either the cis- or trans-isomer (or mixtures thereof) of, for example, 1,4-cyclohexanedimethanol and an alkylene glycol with an aromatic dicarboxylic acid so as to produce a copolyester having repeating units of the following formula:

(XI) 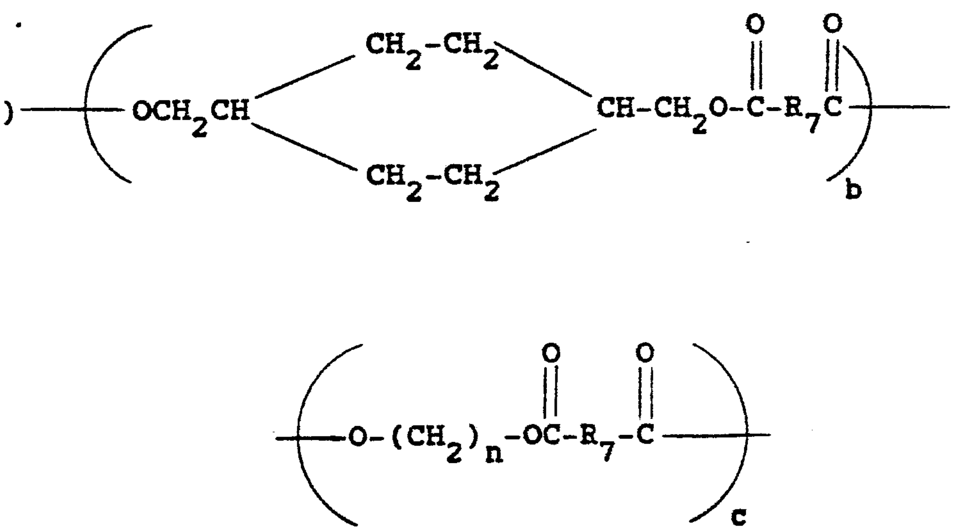

wherein the cyclohexane ring is selected from the cis- and trans- isomers thereof, $R_7$ is as previously defined, n is an integer of 2 to 10, the b units comprise from about 10 to about 90 percent by weight and the c units comprise from about 10 to about 90 percent by weight.

The preferred copolyester may be derived from the reaction of either the cis- or trans-isomer (or mixtures thereof) of 1,4-cyclohexanedimethanol and ethylene glycol with terephthalic acid in a molar ratio of 1:2:3. These copolyesters have repeating units of the following formula:

(XII) 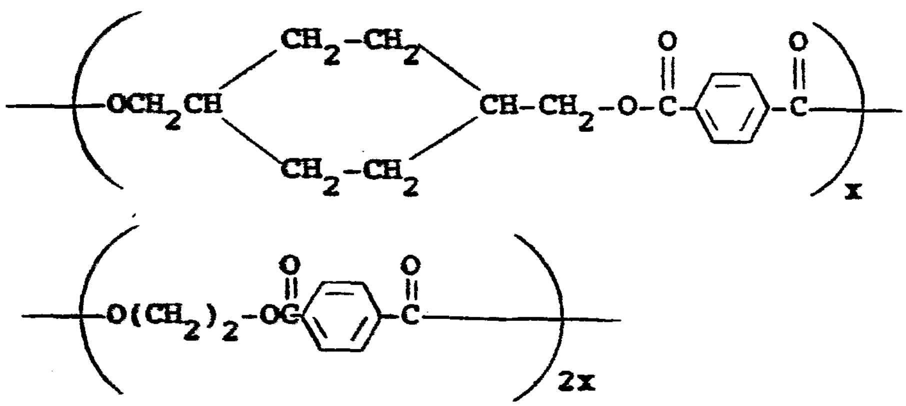

wherein x can be 10 to 10,000. Block as well as random copolymers are possible.

The polyester as described herein are either commercially available or can be produced by methods well known in the art, such as those set forth in, for example, U.S. Patent 2,901,466.

The polyesters used herein have an intrinsic viscosity of from about 0.4 to about 2.0 dl/g. as measured in a 60:40 phenol/tetrachloroethane mixture or similar solvent at 23 to 30°C.

D. Aromatic Polycarbonate

The thermoplastic aromatic polycarbonates that can be employed herein are homopolymers and copolymers and mixtures thereof, which have an intrinsic viscosity of from about 0.4 to about 1.0 dl./g. as measure in methylene chloride at 25°C. The polycarbonates are prepared by reacting a dihydric phenol with a carbonate precursor. Typical of some of the dihydric phenols that may be employed are bisphenol-A, bis(4-hydroxyphenyl)methane, 2,2-bis(4-hydroxy-3-methylphenyl)propane, 4,4-bis(4-hydroxyphenyl)heptane, 2-2-(3,5,3',5'tetrabromo-4,4'-dihydroxydiphenyl)propane, (3,3'dichloro-4,4'dihydroxydiphenyl)methane, and the like. Other dihydric phenols of the bisphenol type are described in, for example, U.S. Patents, 2,999,835, 3,028,365 and 3,334,154.

It is, of course, possible to employ two or more different dihydric phenols or a copolymer of a dihydric phenol with a glycol or with hydroxy or acid terminated polyesters.

The carbonate precursor may be either a carbonyl halide, a carbonate ester, or a haloformate. The carbonyl halides which can be employed herein are carbonyl bromide, carbonyl chloride and mixtures thereof. Typical of the carbonate esters which may be employed herein are diphenyl carbonate, di-(halophenyl)carbonates, such as di-(chlorophenyl)carbonate or di-(bromophenyl)carbonate, etc., di-(alkylphenyl)carbonates such as di(tolyl)carbonate, di(naphthyl)carbonate,

di(chloronaphthyl)carbonate, etc. or mixtures thereof. The haloformates suitable for use herein include bis-haloformate of dihydric phenols for example, bischloroformates of bisphenol-A, of hydroquinone, etc. or glycols for example, bishaloformates of ethylene glycol, neopentyl glycol, polyethylene glycol, etc. While other carbonate precursors will be apparent to those skilled in the art, carbonyl chloride, also known as phosgene, is preferred.

The aromatic polycarbonate polymers may be prepared by methods well known in the art by using phosgene or a haloformate and by employing a molecular weight regulator, an acid acceptor and a catalyst. The molecular weight regulators which can be employed in carrying out the process include monohydric phenols, such as phenol, para-tertiary-butylphenol, para-bromophenol, primary and secondary amines, etc. Preferably, a phenol is employed as the molecular weight regulator.

A suitable acid acceptor may be either an organic or an inorganic acid acceptor. A suitable organic acid acceptor is a tertiary amine and includes materials, such as pyridine, triethylamine, dimethylaniline, tributylamine, etc. The inorganic acid acceptor may be one which can be either a hydroxide, a carbonate, a bicarbonate, or a phosphate of an alkali or alkaline earth metal.

The catalysts which are employed herein can be any of the suitable catalysts that aid the polymerization of, for example, bisphenol-A with phosgene. Suitable catalysts include tertiary

amines, such as triethylamine, tripropylamine, N,N-dimethylaniline, quaternary ammonium compounds, such as tetraethylammonium bromide, cetyl triethyl ammonium bromide, tetra-n-heptylammonium iodide, and quaternary phosphonium compounds, such as n-butyltriphenyl-phosphonium bromide and methyl-triphenyl phosphonium bromide.

The polycarbonates can be prepared in a one-phase (homogeneous solution) or a two-phase (interfacial) systems when phosgene, or a haloformate are used. Bulk reactions are possible when the diarylcarbonate precursors are used.

Also, aromatic polyester carbonates may be used. These are described in, for example, U.S. Patent 3,169,121. The preferred polyester carbonate results from the condensation of phosgene, terephthaloyl chloride, isophthaloyl chloride with bisphenol-A and a small amount of p-tertbutylphenol.

E. Poly(aryl ether)

The poly(aryl ether) polymer may be described as a linear, thermoplastic polyarylene polyether wherein the arylene units are interspersed with other ether, sulfone or ketone linkages. These polymers may be obtained by reaction of an alkali metal double salt of a dihydric phenol and a dihalobenzenoid or dinitrobenzenoid compound, either or both of which contain a sulfone or a ketone linkage, i.e., $-SO_2-$ or -CO-, between arylene groupings, to provide sulfone or ketone units in the polymer chain in addition to arylene units and ether units. The polymer has a basic structure comprising

recurring units of the formula: O-E-O-E' wherein E is the residuum of the dihydric phenol and E' is the residuum of the benzenoid compound having an inert electron withdrawing group in at least one of the positions ortho and para to the valence bonds; both of said residua are valently bonded to the ether oxygens through aromatic carbon atoms. Such aromatic polyethers are included within the class of polyarylene polyester resins described in, for example, U.S. Patents 3,264,536 and 4,175,175. It is preferred that the dihydric phenol be a weakly acidic dinuclear phenol such as, for example, the dihydroxyl diphenyl alkanes or the nuclear halogenated derivatives thereof, such as, for example, 2,2-bis(4-hydroxyphenyl)propane, 1,1-bis(4-hydroxyphenyl)2-phenyl ethane, bis(4-hydroxyphenyl)methane, or their chlorinated derivatives containing one or two chlorines on each aromatic ring. Other materials also termed appropriately "bisphenols" are also highly valuable and preferred. These materials are the bisphenols of a symmetrical or unsymmetrical joining group, as, for example, ether oxygen (-O-), carbonyl ($-\overset{\overset{O}{\|}}{C}-$), sulfone ($-\underset{\underset{O}{\|}}{\overset{\overset{O}{\|}}{S}}-$), or hydrocarbon residue in which the

two phenolic nuclei are joined to the same or different carbon atoms of the residue.

Such dinuclear phenols can be characterized as having the structure:

$$\begin{array}{ccc} (A_1)_a & & (A_2)_b \\ | & & | \\ HO(Ar & -R_1- & Ar)OH \end{array}$$

wherein Ar is an aromatic group and preferably is a phenylene group, $A_1$ and $A_2$ can be the same or different inert substituent groups such as alkyl groups having from 1 to 4 carbons atoms, halogen atoms, i.e., fluorine, chlorine, bromine or iodine, or alkoxyl radicals having from 1 to 4 carbon atoms, a and b are integers having a value from 0 to 4, inclusive, and $R_1$ is representative of a bond between aromatic carbon atoms as in dihydroxyl-diphenyl, or is a divalent radical, including for example, radicals such as $-\overset{O}{\overset{\|}{C}}-$, -O-, -S-, -SO-, -S-S-, $-SO_2$, and divalent hydrocarbon radicals such as alkylene, alkylidene, cycloalkylene, cycloalkylidene, or the halogen, alkyl, aryl or like substituted alkylene, alkylidene and cycloaliphatic radicals as well as aromatic radicals and rings fused to both Ar groups.

Examples of specific dihydric polynuclear phenols including among others: the bis-(hydroxyphenyl) alkanes such as 2,2-bis-(4-hydroxyphenyl)propane, 2,4'-dihydroxydiphenylmethane, bis-(2-hydroxyphenyl)methane,

bis-(4-hydroxyphenyl)methane,
bis(4-hydroxy-2,6-dimethyl-3-methoxyphenyl)methane,
1,1-bis-(4-hydroxyphenyl)ethane,
1,2-bis-(4-hydroxyphenyl)ethane,
1,1-bis-(4-hydroxy-2-chlorophenyl)ethane,
1,1-bis-(3-methyl-4-hydroxyphenyl)propane,
1,3-bis-(3-methyl-4-hydroxyphenyl)propane,
2,2-bis-(3-phenyl-4-hydroxyphenyl)propane,
2,2-bis-(3-isopropyl-4-hydroxyphenyl)propane,
2,2-bis-(2-isopropyl-4-hydroxyphenyl)propane,
2,2-bis-(4-hydroxy-naphthyl)-propane,
2,2-bis-(4-hydroxyphenyl)pentane,
3,3-bis-(4-hydroxyphenyl)pentane,
2,2-bis-(4-hydroxyphenyl)heptane,
bis-(4-hydroxyphenyl)phenylmethane,
2,2-bis-(4-hydroxyphenyl)-1-phenyl-propane,
2,2-bis-(4-hydroxyphenyl)1,1,1,3,3,3,-hexafluoro-propane, and the like;

di(hydroxyphenyl)sulfones such as
bis-(4-hydroxy-phenylsulfone),
2,4'-dihydroxydiphenyl sulfone,
5-chloro-2,4'-dihydroxydiphenyl sulfone,
5'-chloro-4,4'-dihydroxydiphenyl sulfone, and the like;

di(hydroxyphenyl) ethers such as
bis-(4-hydroxyphenyl)ether, the 4,3'-, 4,2'-2,2'-2,3-,dihydroxyphenyl ethers,
4,4'-dihydroxy-2,6-dimethyldiphenyl ether,bis-(4-hydroxy-3-isobutylphenyl) ether,
bis-(4-hydroxy-3-isopropylphenyl) ether,
bis-(4-hydroxy-3-chlorophenyl) ether,
bis-(4-hydroxy-3-fluorophenyl) ether,

bis-(4-hydroxy-3-bromophenyl) ether,
bis-(4-hydroxynaphthyl) ether,
bis-(4-hydroxy-3-chloronaphthyl) ether, and
4,4'-dihydroxy-3,6-dimethoxydiphenyl ether.

As herein used the E term defined as being the "residuum of the dihydric phenol" of course refers to the residue of the dihydric phenol after the removal of the two aromatic hydroxyl groups. Thus as is readily seen these polyarylene polyethers contain recurring groups of the residuum of the dihydric phenol and the residuum of the benzenoid compound bonded through an aromatic ether oxygen atom.

Any dihalobenzenoid or dinitrobenzenoid compound or mixtures thereof can be employed in this invention, which compound or compounds has the two halogens or nitro-groups bonded to benzene rings having an electron withdrawing group in at least one of the positions ortho and para to the halogen or nitro group. The dihalobenzenoid or dinitrobenzenoid compound can be either mononuclear where the halogens or nitro groups are attached to the same benzenoid rings or polynuclear where they are attached to different benzenoid rings, as long as there is an activating electron withdrawing group in the ortho or para position of that benzenoid nucleus. Fluorine and chlorine substituted benzenoid reactants are preferred; the fluorine compounds for fast reactivity and the chlorine compounds for their inexpensiveness. Fluorine substituted benzenoid compounds are most preferred, particularly when there is a trace of water present

in the polymerization reaction system. However, this water content should be maintained below about 1% and preferably below 0.5% for best results.

An electron withdrawing group can be employed as the activator group in these compounds. It should be, of course, inert under the reaction conditions, but otherwise its structure is not critical. Preferred are the strong activating groups such as the sulfone group 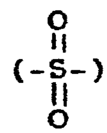 bonding two halogen or nitro substituted benzenoid nuclei as in the 4,4'-dichlorodiphenyl sulfone and 4,4'-difluorodiphenyl sulfone, although such other strong withdrawing groups hereinafter mentioned can also be used with equal ease.

The more powerful of the electron withdrawing groups give the fastest reactions and hence are preferred. It is further preferred that the ring contain no electron supplying groups on the same benzenoid nucleus as the halogen or nitro group; however, the presence of other groups on the nucleus or in the residuum of the compound can be tolerated. Preferably, all of the substituents on the benzenoid nucleus are either hydrogen (zero electron withdrawing), or other groups having a positive sigma* value, as set forth in J.F. Bunnett in Chem. Rev. 49 273 (1951) and Quart. Rev., 12, 1 (1958). See also Taft, Steric Effects in Organic Chemistry, John Wiley & Sons (1956), chapter 13; Chem. Rev., 53, 222; JACS, 74, 3120; and JACS, 75, 4231.

The activating group can be basically either of two types:

(a) monovalent groups that activate one or more halogens or nitro-groups on the same ring such as another nitro or halo group, phenylsulfone, or alkylsulfone, cyano, trifluoromethyl, nitroso, and hetero nitrogen, as in pyridine.

(b) divalent groups which can activate displacement of halogens on two different rings, such as the sulfone group $-\overset{\overset{O}{\|}}{\underset{\underset{O}{\|}}{S}}-$; the carbonyl group $-\overset{\overset{O}{\|}}{C}-$; the vinylene group $-\overset{\overset{H}{|}}{C}=\underset{\underset{H}{|}}{C}-$; the sulfoxide group $-\overset{\overset{O}{\|}}{S}-$; the azo-group -N=N=; the saturated fluorocarbon groups $-CF_2CF_2-$; organic phosphine oxides $-\overset{\overset{O}{\|}}{\underset{\underset{R_2}{\|}}{P}}-$:

where $R_2$ is a hydrocarbon group, and the ethylidene group $X_1-\underset{\underset{-C-}{|}}{C}-X_1$ where $X_1$ can be hydrogen or halogen and activating groups within the nucleus which can activate halogens as nitro functions on the same ring such as in the case with difluorobenzoquinone, 1,4- or 1,5- or 1,8-difluoroanthroquinone, etc.

If desired, the polymers may be made with mixtures of two or more dihalobenzenoid or dinitrobenzenoid compounds. Thus, the E'residuum of the benzenoid compounds in the polymer structure may be the same or different.

It is seen also that as used herein, the E' term defined as being the "residuum of the benzenoid compound" refers to the aromatic or benzenoid residue of the compound after the removal of the halogen atom or nitro group on the benzenoid nucleus. The polyarylene polyethers of this invention are prepared by methods well known in the art as for instance the substantially equimolar one-step reaction of a double alkali metal salt of dihydric phenol with a dihalobenzenoid compound in the presence of specific liquid organic sulfoxide or sulfone solvents under substantially anhydrous conditions. Catalysts are not necessary for this reaction.

The polymers may also be prepared in a two-step process in which a dihydric phenol is first converted <u>in situ</u> in the primary reaction solvent to the alkali metal salt of the reaction with the alkali metal, alkali metal hydride, alkali metal hydroxide, alkali metal alkoxide or the alkali metal alkyl compounds. Preferably, the alkali metal hydroxide is employed. After removing the water which is present or formed, in order to secure substantially anhydrous conditions, the dialkali metal salts of the dihydric phenol are admixed and reacted with about stoichiometric quantities of the dihalobenzenoid or dinitrobenzenoid compound.

The polymerization reaction proceeds in the liquid phase of a sulfoxide or sulfone organic solvent at elevated temperatures.

A preferred form of the poly(aryl ether) of this invention are those prepared using the dihydric polynuclear phenols of the following four types, including the derivatives thereof which are substituted with inert substituent groups

(a) 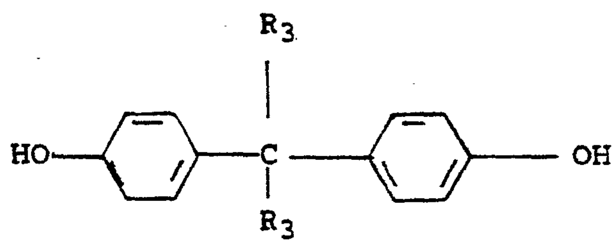

in which the $R_3$ group represents independently hydrogen, lower alkyl, aryl and the halogen substituted groups thereof, which can be the same or different;

(b) 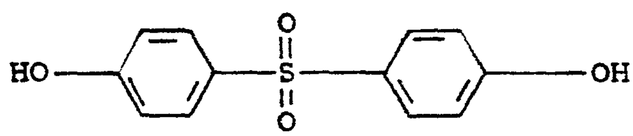

and substituted derivatives thereof.

It is also contemplated in this invention to use a mixture of two or more different dihydric phenols to accomplish the same ends as above. Thus when referred to above the -E- residumm in the polymer structure can actually be the same or different aromatic residua.

In order to secure the high polymers, the system should be substantially anhydrous, and preferably with less than 0.5 per cent by weight water in the reaction mixtures.

The poly(aryl ether)s have a reduced viscosity of from about 0.35 to about 1.5 as measured in an appropriate solvent at an appropriate temperature depending on the particular poly(aryl ether), such as in methylene chloride at 25°C.

The preferred poly(aryl ether)s have repeating units of the formula:

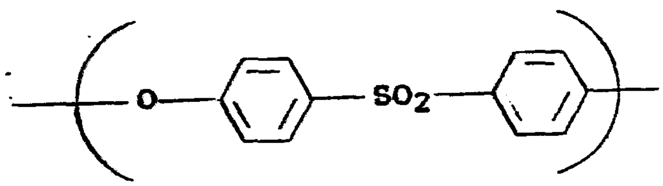

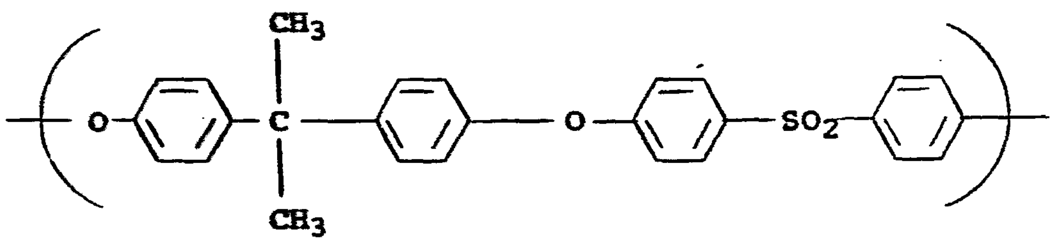

Also, included within the poly(aryl ether) is a polyarylethersulfone which is an amorphous thermoplastic polymer containing units of the formula:

(III) 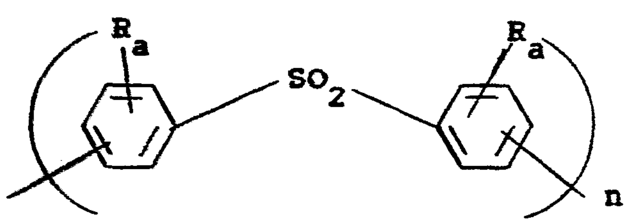 , and

(IV) 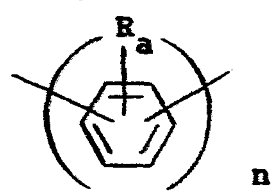

wherein R is independently hydrogen, $C_1$ to $C_6$ alkyl or $C_4$ to $C_8$ cycloalkyl, a is an integer of

0 to 4 and n is independently an integer of 1 to 3 and wherein the ratio of unit (III) to unit (IV) is greater than 1. The units are attached to each other by an -O- bond. The polyarylethersulfone contains from about 10 to about 75, and preferably from about 20 to about 65 mole percent of unit (IV), said mole percent based on the total dihydroxy starting material. The polymer may additionally contain the following unit:

(V) 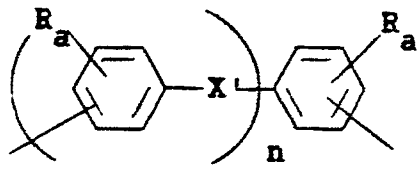

wherein R is as defined above, X' is independently

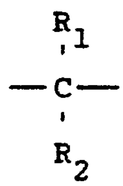

wherein $R_1$ and $R_2$ are independently hydrogen or $C_1$ to $C_9$ alkyl; 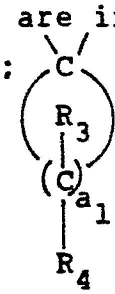 wherein $R_3$ and $R_4$ are independently hydrogen or $C_1$ to $C_8$ alkyl; and $a_1$ is an integer of 2 to 7; -S-, -O-, or H , a and n are as defined above.

A preferred polymer of this invention contains units of the formula:

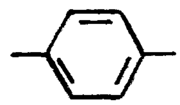

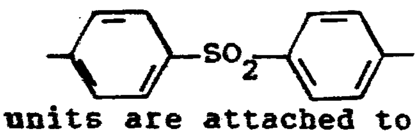 , and

These units are attached to each other by an -O- bond. The polyarylethersulfone may be random or may have an ordered structure.

The polyarylethersulfones of this invention have a reduced viscosity of from about 0.4 to greater than about 2.5, as measured in N-methylpyrrolidone, or other suitable solvent, at 25°C.

The polyarylethersulfones of this invention are prepared by reacting the monomers represented by the following formulae:

(VI) 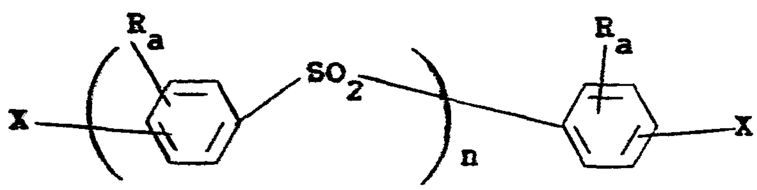

(VII) 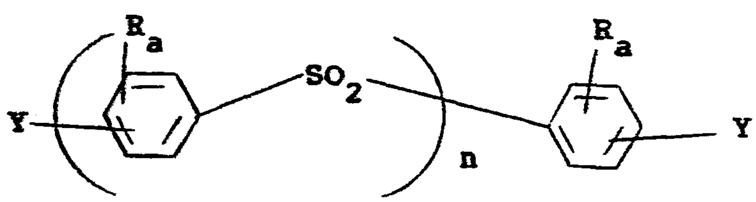

(VIII) and 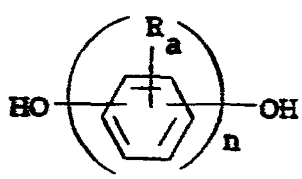 , optionally

(IX) 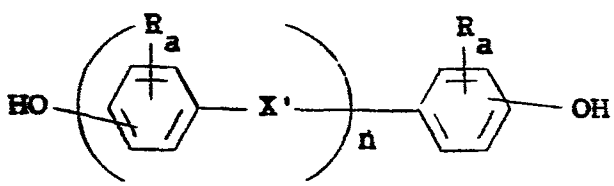

wherein R, a, X' and n are as previously defined, and X and Y are independently selected from Cl, Br, F, $NO_2$ or OH and at least 50 percent of the Y's are OH.

The ratio of the concentration of OH groups to Cl, Br, F and/or $NO_2$ groups used to form the polyarylethersulfone is from about 0.90 to about 1.10, preferably from about 0.98 to about 1.02.

The monomers, represented by formulas (VI), (VII), (VIII), and (IX) include the following:

4,4' -dihydroxydiphenyl sulfone,
2,4' -dihydroxydiphenyl sulfone,
4,4' -dichlorodiphenyl sulfone,
4,4' -dinitrodiphenyl sulfone,
4-chloro-4'-hydroxydiphenyl sulfone,
2,2-bis(4-hydroxyphenyl) propane, 4,4'-biphenol, hydroquinone, resorcinol, and the like.

The preferred monomers include hydroquinone, 4,4'-biphenol, 4,4'-dichlorodiphenyl sulfone, and 4,4'-dihydroxydiphenyl sulfone, or 4-chloro -4'- hydroxydiphenyl sulfone.

The polymers of this invention are prepared by contacting substantially equimolar amounts of the hydroxy containing compounds (depicted in formulas (VI) to (IX) supra) and halo and/or nitro containing compounds (depicted in formula (VI) and (VII) supra) with from about 0.5 to about 1.0 mole of an alkali metal carbonate per mole of hydroxyl group in a solvent mixture comprising a solvent which forms an azeotrope with water in order to maintain the reaction medium at substantially anhydrous conditions during the polymerization.

The temperature of the reaction mixture is kept at from about 120 to about 180°C, for about 1 to about 5 hours and then raised and kept at from about 200 to about 250°C, preferably from 210 to about 230°C, for about 1 to 10 hours.

The reaction is carried out in an inert atmosphere, e.g., nitrogen, at atmospheric pressure, although higher or lower pressures may also be used.

The polyarylethersulfone is then recovered by conventional techniques such as coagulation, solvent evaporation, and the like.

The solvent mixture comprises a solvent which forms an azeotrope with water and a polar aprotic solvent. The solvent which forms an azeotrope with water includes an aromatic hydrocarbon such as benzene, toluene, xylene, ethylbenzene, chlorobenzene, and the like.

The polar aprotic solvents employed in this invention are those generally known in the art for the manufacture of polyarylether sulfones and include sulfur containing solvents such as those of the formula:

$$R_5 - S(O)_b - R_5$$

in which each $R_5$ represents a monovalent lower hydrocarbon group free of aliphatic unsaturation, which preferably contains less than about 8 carbon atoms or when connected together represents a divalent alkylene group with b being an integer from 1 to 2 inclusive. Thus, in all of these solvents all oxygens and two carbon atoms are bonded to the

sulfur atom. Contemplated for use in this invention are such solvents as those having the formula:

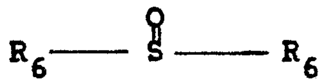 and 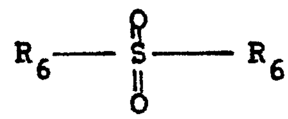

where the $R_6$ groups are independently lower alkyl, such as methyl, ethyl, propyl, butyl, and like groups, and aryl groups such as phenyl and alkylphenyl groups such as the tolyl group, as well as those where the $R_6$ groups are interconnected as in a divalent alkylene bridge such as:

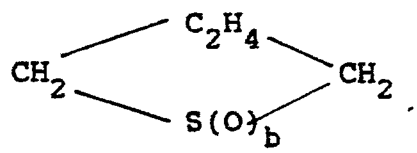

in tetrahydrothiophene oxides and dioxides. Specifically, these solvents include dimethylsulfoxide, dimethylsulfone, diphenylsulfone, diethylsulfoxide, diethylsulfone, diisopropylsulfone, tetrahydrothiophene, 1,1-dioxide (commonly called tetramethylene sulfone or sulfolane) and tetrahydrothiophene-1 monoxide.

Additionally, nitrogen containing solvents may be used. These include dimethylacetamide, dimethylformamide and N-methylpyrrolidone.

The azeotrope forming solvent and polar aprotic solvent are used in a weight ratio of from about 1:10 to about 1:1, preferably from about 1:5 to about 1:3.

In the reaction, the hydroxy containing compound is slowly converted, <u>in situ</u>, to the alkali salt thereof by reacting with the alkali metal carbonate. The alkali metal carbonate is preferably

potassium carbonate. Mixtures of carbonates such as potassium and sodium carbonate may also be used.

Water is continuously removed from the reaction mass as an azeotrope with the azeotrope forming solvent so that substantially anhydrous conditions are maintained during the polymerization.

It is essential that the reaction medium be maintained substantially anhydrous during the polycondensation. While amounts of water up to about one percent can be tolerated, and are somewhat beneficial when employed with fluorinated dihalobenzenoid compounds, amounts of water substantially greater than this are desirably avoided as the reaction of water with the halo and/or nitro compound leads to formation of phenolic species and only low molecular weight products are secured. Consequently, in order to secure the high polymers, the system should be substantially anhydrous, and preferably contain less than 0.5 percent by weight water during the reaction.

Preferably, after the desired molecular weight has been attained, the polymer is treated with an activated aromatic halide or an aliphatic halide such as methyl chloride or benzyl chloride, and the like. Such treatment of the polymer converts the terminal hydroxyl groups into ether groups which stabilize the polymer. The polymer so treated has good melt and oxidative stability.

The polymers may be combined with other ingredients such as stabilizers, i.e., metal oxides such as zinc oxide, antioxidants, flame retardants, pigments, fibers, inorganic fillers, and the like.

Preferably, the polymers may be combined with fibers and/or inorganic fillers.

The reinforcing fiber includes fiberglass, carbon fibers, and the like, and mixtures thereof. The particulate inorganic fillers which may be used include wollastonite, calcium carbonate, glass beads, talc, mica and the like, or mixtures thereof.

The fiber reinforcement, filler or combinations thereof, may be utilized in amounts of from 0 to about 50 weight percent, preferably from about 10 to about 35 weight percent.

The compositions herein are prepared by any conventional mixing methods. For example, a preferred method comprises mixing the polymer and other optional ingredients in powder or granular form in an extruder and extruding the mixture into strands, chopping the strands into pellets and molding the pellets into the desired circuit board substrate and electrical connector.

The composition of this invention can be molded into substrates, particularly circuit board substrates using conventional molding techniques. The molded boards are then swelled and etched to promote the adhesion of copper by both roughening the surface and introducing chemical moieties through oxidation. The circuitry is then applied to the board by either a conventional additive or a semiadditive process. In either case copper is applied to the substrate in an electroless manner after the application of catalysts which activate the surface to the deposition of metal in a conventional manner.

## EXAMPLES

The following Examples serve to give specific illustrations of the practice of this invention but they are not intended in any way to limit the scope of this invention.

The following polymers were used to mold circuit board substrates:

Polymer I

A four neck 1000 ml round-bottom flask was equipped with a mechanical stirrer, thermometer, addition funnel, dry nitrogen inlet, and vacuum jacketed vigreux column with a distillate collector and condenser. Into the flask were charged 143.58 g (0.50 moles) of 4,4'-dichlorodiphenyl sulfone 112.62 (0.45 moles) of 4,4'-dihyroxydiphenyl sulfone, 5.51 g (0.05 moles) of hydroquinone, 76.02 g (0.55 moles) of potassium carbonate, 150 g of monochlorobenzene and 460 g of sulfolane. The mixture was purged with nitrogen for 1 hour at room temperature and then heated to reflux (150°C). After 1 hour at reflux, the temperature of the reaction was increased to about 235°C by slowly removing the monochlorobenzene. After about 5 hours at 235°C, the reaction was diluted with monochlorobenzene and terminated by adding methyl chloride. The polymer so produced was recovered by coagulation in methanol followed by washing the polymer several times with hot water (80°C). A theoretical yield of the polymer was obtained. The polymer had a reduced viscosity of 0.61 dl/g as measured in N-methylpyrrolidone (0.2 g/100 ml) at 25°C. The polymer was made up of the following repeating unit:

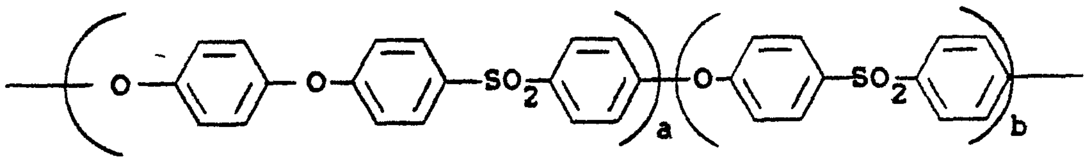

Polymer 2

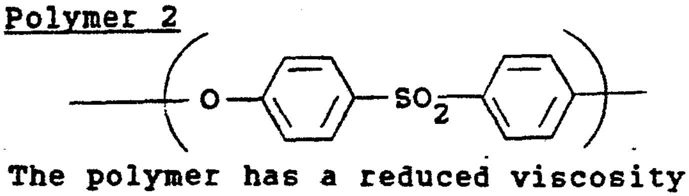

The polymer has a reduced viscosity of 0.3 dl/g as measured in N-methylpyrrolidone at 25°C.

Polymer 3

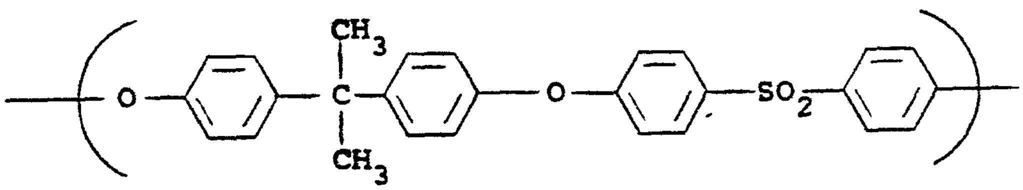

The polymer has a reduced viscosity of 0.43 as measured in chloroform (0.2 gram polymer in 100 ml at 25°C).

Polymer 4

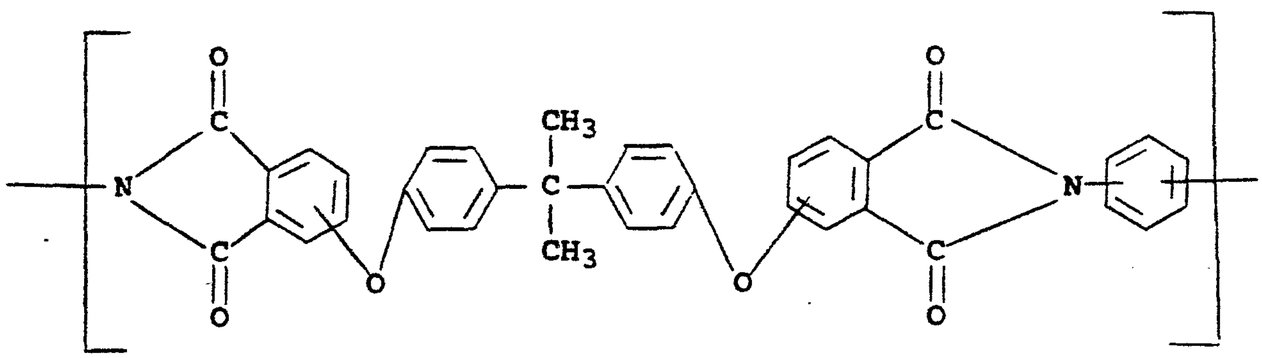

The polymer has reduced viscosity of 0.51 as measured in chloroform (0.5 gram polymer in 100 ml at 25°C).

0162230

Substrates were molded from the polymers in a 4x4x0.125 inch cavity mold. The mold was placed between the heated platins of a South Bend hydraulic press at 300°C. After forming under pressure to produce a plaque, the mold was cooled slowly over a period of about five minutes to room temperature. The substrates were immersed in a dimethylformamide solution (specific gravity = 0.957) for 3 to 5 minutes at 23°C. This constituted the pre-etch. The substrates were then rinsed (5 min @ 30°C) and immersed in an etch which was a chromic acid solution of the following composition:

| | | |
|---|---|---|
| 96% $H_2SO_4$ | - | 55.9 weight % |
| 87% $H_3PO_4$ | - | 10.4 weight % |
| $CrO_3$ | - | 3.0 weight % |
| $H_2O$ | - | 30.7 weight % |

Etching was accomplished in 3 to 5 minutes at 158°F. Following treatment, the surfaces of the substrates were opaque.

The substrates were then immersed in vapors of methylene chloride in a container for 0.5 to 3 seconds. The surfaces of the substrate were then restored essentially to the same condition as before etching.

0162230

CLAIMS:

1. A method for restoring the surface of a substrate molded from a thermoplastic polymer after its surface has undergone conditioning by a strong oxidizing or reducing agent and/or mechanical abrasion which comprises exposing the surface of the substrate to solvent vapors for a period of time sufficient to restore the surface to essentially that before conditioning.

2. A process as defined in claim 1 wherein the solvent is selected from methylene chloride, chloroform, carbon tetrachloride, trichloroethane, trichloroethylene, trichloromethylene, o-dichlorobenzene, acetone, methyl ethyl ketone, cyclohexanone, ethyl acetate, dimethyl acetamide, N-methyl pyrolidine or N,N-dimethylformamide.

3. A process as defined in claim 1 or 2 wherein the thermoplastic polymer is a polyarylate, especially a polyarylate derived from a dihydric phenol and at least one aromatic dicarboxylic acid, a polyester or a polyarylether, preferably a polyarylether with repeating units of the formula:

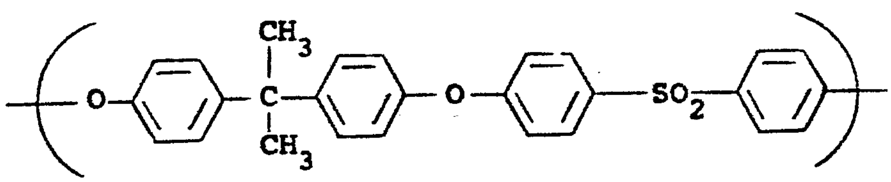

or

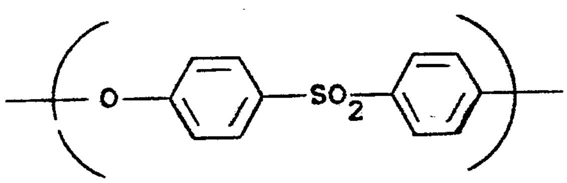

4. A process as defined in claim 1 or 2 wherein the thermoplastic polymer is a polyetherimide, preferably a poly(etherimide) polymer of the following formula:

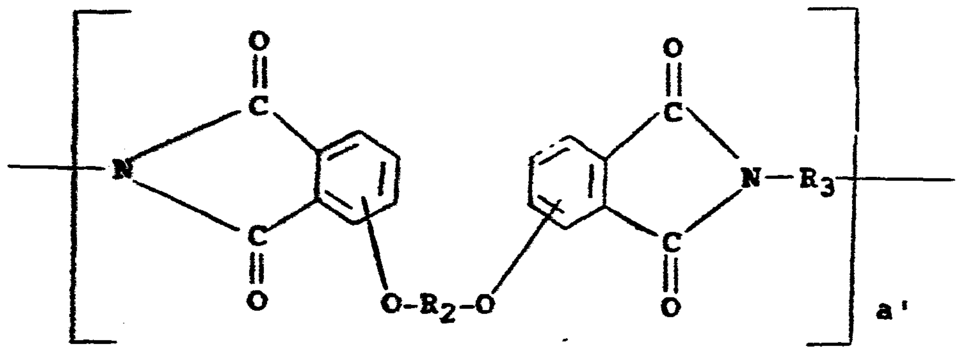

wherein a' is an integer greater than 1, $-O-R_2-O-$ is attached to the 3 or 4 and 3' or 4' positions and $R_2$ is selected from (a) a substituted or unsubstituted aromatic radical of the formula:

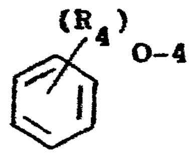

, or

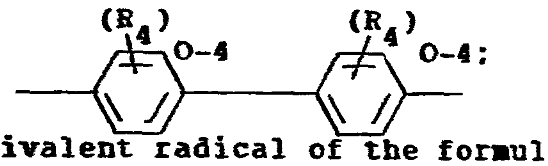

(b) a divalent radical of the formula:

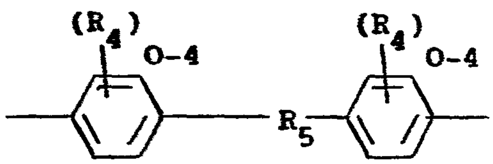

wherein $R_4$ is independently $C_1$ to $C_6$ alkyl, or halogen and

$R_5$ is selected from -O-, -S-, $-\overset{O}{\overset{\|}{C}}-$, -SO-, $-SO_2-$, alkylene of 1 to 6 carbon atoms, cycloalkylene of 4 to 8 carbon atoms, alkylidene of 1 to 6 carbon atoms or cycloalkylidene of 4 to 8 carbon atoms, $R_3$ is selected from aromatic hydrocarbon radical having from 6-20 carbon atoms and halogenated derivatives

thereof, or alkyl substituted derivatives thereof, wherein the alkyl group contains 1 to 6 carbon atoms, alkylene and cycloalkylene radicals having from 2 to 20 carbon atoms and $C_2$-$C_8$ alkylene terminated polydiorganosiloxane.

5. A process as defined in claim 1 or 2 wherein the thermoplastic polymer is an aromatic polycarbonate, preferably the reaction product of a dihydric phenol and a carbonate precursor, or a poly(ester carbonate).

6. A process as defined in claim 5 wherein the dihydric phenol is bisphenol-A and the carbonate precursor is carbonyl chloride or diphenyl carbonate.

7. A process as defined in claim 1 or 2 wherein the polymer contains units of the following formula:

(III) 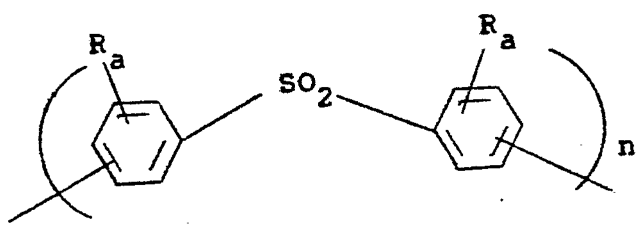 , and

(IV) 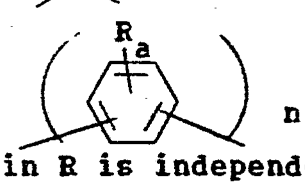

wherein R is independently hydrogen, $C_1$ to $C_6$ alkyl or $C_4$ to $C_8$ cycloalkyl, a is an integer of 0 to 4 and n is independently an integer of 1 to 3 and wherein the ratio of unit (III) to unit (IV) is greater than 1; said units (III) and (IV) being attached to each other by an -O- bond, and wherein unit (IV) is present in the polymer in amounts of from about 10 to about 75 mole percent, said mole percent based on the total dihydroxy starting material.

8. A process as defined in claim 7, wherein unit (III) has the formula:

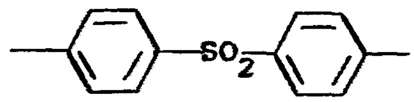

9. A process as defined in claim 7, wherein unit (IV) has the formula:

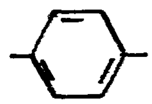

10. A process as defined in claim 7 wherein the polymer contains recurring units of the formula:

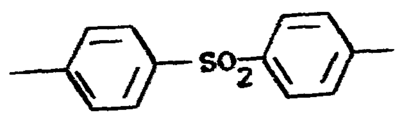

, and

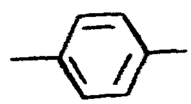

said units being attached to each other by an -O- bond.

11. A process as defined in any of claims 1 to 10 wherein the substrate is a circuit board.